# EUROPÄISCHE PATENTANMELDUNG

(11) **EP 2 339 157 A1**
(43) Veröffentlichungstag der Anmeldung: **29.06.2011**
(21) Anmeldenummer: 10178652.3
(22) Anmeldetag: 23.09.2010
(51) Int. Cl.: F02D 41/20, F02M 51/06, F02M 61/08, H01L 41/04

(54) **Einspritzsystem mit bipolar betriebenem Piezostellglied**

(30) Priorität: 22.12.2009 DE 102009055136
(71) Anmelder: Robert Bosch GmbH, 70442 Stuttgart (DE)
(72) Erfinder: Wuerfel, Gernot, 71665 Vaihingen/Enz (DE); Kerkamm, Ingo, 70565 Stuttgart-Rohr (DE); Kessler, Martin, 73527 Schwaebisch Gmuend (DE); Hejtmann, Georg, 74395 Mundelsheim (DE); Jakobi, Andreas, 70563 Stuttgart (DE); Spremo, Ivan, 70197 Stuttgart (DE); Konstandin, Alexander, 74862 Binau (DE)

(57) **Zusammenfassung**

Ein Einspritzsystem (1), das insbesondere als Brennstoffeinspritzanlage ausgestaltet ist, umfasst einen Aktor (10), einen vom dem Aktor betätigbaren Ventilschließkörper (19), der mit einer Ventilsitzfläche (20) zu einem Dichtsitz zusammenwirkt, und eine mit dem Aktor (10) verbundene Steuerung (17), die zur Ansteuerung des Aktors (10) dient. Hierbei ist die Steuerung (17) ausgestaltet, den Aktor (10) entsprechend einer Polarisierung des Aktors (10) und entgegen der Polarisierung des Aktors (10) anzusteuern. Ferner steuert die Steuerung (17) den Aktor (10) hierbei so entgegen der Polarisierung des Aktors (10) an, dass ein Schließen des zwischen dem Ventilschließkörper (19) und der Ventilsitzfläche (20) gebildeten Dichtsitzes ermöglicht ist.

## Beschreibung

### Stand der Technik

Die Erfindung betrifft ein Einspritzsystem, insbesondere eine Brennstoffeinspritzanlage mit einem piezoelektrischen Aktor und einer Steuerung. Speziell betrifft die Erfindung das Gebiet der Brennstoffeinspritzanlagen von luftverdichtenden, selbstzündenden Brennkraftmaschinen oder von gemischverdichtenden, fremdgezündeten Brennkraftmaschinen.

Aus der DE 101 62 250 A1 ist ein Brennstoffeinspritzventil zum direkten Einspritzen von Brennstoff in einen Brennraum einer Brennkraftmaschine bekannt. Das bekannte Brennstoffeinspritzventil weist einen piezoelektrischen Aktor und einen von dem Aktor betätigbaren Ventilschließkörper auf, der mit einer Ventilsitzfläche zu einem Dichtsitz zusammenwirkt. Hierbei ist in einem Betätigungspfad zwischen dem Aktor und dem Ventilschließkörper ein Ausgleichsspalt vorhanden. In dem Aktor ist ein Messelement vorgesehen, das die durch den Aktor auf den Ventilschließkörper ausgeübten Kräfte misst. Der Aktor wird so geregelt, dass der Ausgleichsspalt geschlossen gehalten wird.

Das aus der DE 101 62 250 A1 bekannte Brennstoffeinspritzventil hat den Nachteil, dass der zur Betätigung des Brennstoffeinspritzventils verfügbare Hub reduziert ist. Somit ist ein entsprechend langer Aktor erforderlich, was sich auf die Baugröße des Brennstoffeinspritzventils auswirkt.

### Offenbarung der Erfindung

Das erfindungsgemäße Einspritzsystem mit den Merkmalen des Anspruchs 1 hat den Vorteil, dass eine verbesserte Ansteuerung des piezoelektrischen Aktors erzielt ist. Speziell kann ein verfügbarer Hub des Aktors in vorteilhafter Weise zur Betätigung des Ventilelements genutzt werden und stets ein Schließen des Dichtsitzes erzielt werden kann.

Durch die in den Unteransprüchen aufgeführten Maßnahmen sind vorteilhafte Weiterbildungen des im Anspruch 1 angegebenen Einspritzsystems möglich.

Der piezoelektrische Aktor ist in vorteilhafter Weise als piezoelektrischer Vielschichtaktor ausgestaltet. Piezoelektrische Vielschichtaktoren sind metallisierte keramische Bauelemente, die als Stellelemente dienen. Die geregelte Einspritzung von Brennstoff in Kraftfahrzeuganwendungen stellt einen bevorzugten Einsatzbereich dar. Hierbei kann ein Injektor mit dem piezoelektrischen Aktor als direkt oder indirekt schaltender Injektor ausgestaltet sein. Bei direktschaltenden Injektoren steht der Vielschichtaktor in unmittelbarem Kontakt mit einem als Düsennadel ausgestalteten Ventilelement, so dass eine spannungs- oder ladungsgesteuerte Auslenkung des piezoelektrischen Aktors eine direkte Öffnung des Steuerventils zur Folge hat. Bei indirekt schaltenden Injektoren wird über ein Servoventil eine Bewegungsumkehr realisiert. Der Aktor und die Düsennadel bewegen sich dabei in entgegengesetzte Richtungen.

Vorzugsweise ist bei dem Einspritzsystem eine direkte Schaltung realisiert. Allerdings besteht bei direkt schaltenden Injektoren das Problem, dass auf Grund unterschiedlicher Wärmeausdehnungskoeffizienten des keramischen Materials des piezoelektrischen Aktors und eines Ventilgehäuses Spalte in der Wirkungskette zwischen dem piezoelektrischen Aktor und dem Ventilelement auftreten können. Hierbei weist das piezokeramische Material in der Regel sehr niedrige oder auch negative Wärmeausdehnungskoeffizienten auf, während das üblicherweise aus Stahl ausgestaltete Ventilgehäuse einen positiven Wärmeausdehnungskoeffizienten hat. In einem Einsatzbereich von beispielsweise -40 °C bis etwa 150 °C kann sich eine thermische Inkompatibilität von ca. 130 µm ergeben. Um eine Spaltbildung bei hohen Temperaturen zwischen dem Aktor und dem Ventilelement zu vermeiden und eine konstante Anpresskraft des Aktors gegen das Ventilelement zu gewährleisten, ist es denkbar, dass ein hydraulischer Koppler eingesetzt wird. Solch ein hydraulischer Koppler kann nahezu statisch ablaufende Längenänderungen kompensieren, verhält sich bei dynamischen Prozessen, die bei der Ansteuerung des Aktors auftreten, jedoch sehr steif und ermöglicht so eine Bewegung der Düsennadel. Allerdings stellt solch ein hydraulischer Koppler ein zusätzliches Bauteil dar, so dass das Einspritzsystem vorzugsweise ohne solch eines hydraulischen Kopplers ausgestaltet ist.

Hierbei ist der piezoelektrische Aktor in vorteilhafter Weise an einer Stirnseite an dem Ventilgehäuse abgestützt, wobei ein Abstand der Stirnseite des Aktors von dem Ventilgehäuse durch die Abstützung fest vorgegeben ist. Zur Verringerung von temperaturbedingten Längenänderungen ist es ferner vorteilhaft, dass zumindest ein Werkstoff des Ventilgehäuses so vorgegeben ist, dass temperaturbedingte Längenänderungen in der Wirkverbindung zwischen dem Aktor und dem Ventilelement reduziert sind. Hierdurch verringert sich das Ausmaß der von der Steuerung zum Aufrechterhalten der Wirkverbindung zwischen dem Aktor und dem Ventilelement erforderlichen Ausgleichsansteuerungen des Aktors. Somit kann in vorteilhafter Weise ein Einspritzsystem mit einem direktschaltenden Injektor realisiert werden, wobei ein hydraulischer Koppler eingespart werden kann. Beispielsweise kann durch die optimierte Ausgestaltung des Ventilgehäuses eine Spaltbildung zwischen dem Aktor und dem Ventilelement in einem relevanten Temperaturbereich, beispielsweise von -40 °C bis 150 °C, auf wenige µm reduziert werden.

Ein gegebenenfalls noch vorhandener Spalt zwischen dem Aktor und dem Ventilelement in der Wirkverbindung zwischen dem Aktor und dem Ventilelement, der durch Fertigungstoleranzen, Verschleiß oder einen ungenügenden Ausgleich der unterschiedlichen Wärmeausdehnungskoeffizienten entsteht, kann dann in vorteilhafter Weise durch die Steuerung ausgeglichen werden. Der Hub des Aktors steht hierbei zumindest weitgehend zum Betätigen des Ventilelements zur Verfügung. Der Ausgleich des Spalts erfolgt über eine adaptive Längenanpassung des piezoelektrischen Aktors, wobei eine bipolare elektrische Ansteuerung erfolgt. Hierbei wird der Aktor von der Steuerung zum Betätigen des Ventilelements entsprechend der Polarisierung des Aktors und entgegen der Polarisierung des Aktors angesteuert, wobei durch eine Ansteuerung entgegen der Polarisierung des Aktors eine Verringerung eines Remanenzzustandes des piezoelektrischen Materials des Aktors erreicht wird.

Die adaptive Längeneinstellung des piezoelektrischen Aktors erfolgt durch die gezielte bipolare beziehungsweise quasi bipolare Ansteuerung. Hierdurch ist eine Spaltbildung zwischen dem Aktor und dem Ventilelement auch bei einem direktschaltenden Injektor verhindert und es kann eine konstante Anpresskraft des Aktors gegen das Ventilelement erzielt werden. Zur Erfassung, wann sich der Aktor in direktem Kontakt mit dem Ventilelement befindet, kann der Aktor selbst herangezogen werden. Speziell kann ein Lade- und Entladeverhalten des Aktors ausgewertet werden.

Möglich ist es auch, dass der Aktor ein Sensorelement aufweist, dass zum Erfassen einer mechanischen Spannung in der Wirkverbindung zwischen dem piezoelektrischen Aktor und dem Ventilelement dient, und dass die Steuerung den piezoelektrischen Aktor in Abhängigkeit von der von dem Sensorelement erfassten mechanischen Spannung entgegen der Polarisation des Aktors ansteuert. Solch ein Sensorelement kann hierbei piezokeramische Schichten umfassen, die in den Aktor integriert sind.

Somit kann sowohl in dem Fall, in dem das Verhalten des Aktors ausgewertet wird, als auch in dem Fall, in dem ein Sensorelement eingesetzt wird, der direkte piezoelektrische Effekt genutzt werden, wonach es bei mechanischer Belastung der piezokeramischen Schichten zu einer proportionalen Ladungserzeugung auf den Keramikoberflächen kommt.

Beispielsweise kann eine mechanische Vorspannung des Aktors von 100 N vorgegeben sein. Falls die mechanische Vorspannung auf beispielsweise 180 N oder mehr ansteigt, dann ist der Dichtsitz permanent geöffnet. Ein vollständiges Schließen ist zu diesem Zeitpunkt mit einer elektrischen Ansteuerung des Aktors von 0 V nicht mehr möglich. Durch Ansteuern des Aktors entgegen seiner Polarisation kann der Aktor aber verkürzt werden, so dass sich auch die Vorspannung verringert. Speziell kann die mechanische Vorspannung des Aktors wieder auf 100 N eingestellt werden. Ein Schließen des Dichtsitzes ist dann wieder möglich.

Speziell kann die Steuerung die von dem Sensorelement erfasste mechanische Spannung im Sinne einer Regelung nutzen. Hierbei kann die Steuerung den Aktor in vorteilhafter Weise so ansteuern, dass die von dem Sensorelement erfasste mechanische Spannung zumindest näherungsweise gleich einer vorgegebenen mechanischen Sollspannung ist. Hierdurch kann eine durch die mechanische Sollspannung vorgegebene Anpresskraft des Aktors an das Ventilelement erzielt werden. Gegebenenfalls kann auch ein Spalt mit einem definierten Abstand eingehalten werden.

Vorteilhaft ist es, dass der Aktor so angeordnet ist, dass in einem Ausgangszustand bei einer teilweisen Ansteuerung des Aktors entsprechend der Polarisierung des Aktors eine Wirkverbindung zwischen dem piezoelektrischen Aktor und dem Ventilelement besteht. Ferner ist es vorteilhaft, dass der Aktor das Ventilelement direkt ansteuert. Durch die konstruktive Ausgestaltung des Injektors, insbesondere des Ventilgehäuses, in dem der Aktor angeordnet ist, kann erreicht werden, dass zwischen dem Aktor und dem Ventilelement bei mittlerer quasi bipolarer Ansteuerung und somit mittlerer Aktorlänge des Aktors kein Spalt zwischen dem Aktor und dem Ventilelement auftritt. Hierdurch können im Betrieb auftretenden Spalte durch die adaptive Längenänderung des Aktors vermieden werden. Hierbei kann die Steuerung nur die Größe der negativen Feldkomponente variieren, wobei eine Ansteuerung des Aktors entgegen der Polarisierung des Aktors erfolgt, und somit einen angepassten Remanenzzustand einstellen.

Ferner ist es vorteilhaft, dass die Steuerung so ausgestaltet ist, dass eine negative Längenänderung einer Ausgangslänge des Aktorkörpers durch Ansteuerung des Aktors entgegen der Polarisierung des Aktors möglich ist. Hierdurch kann stets ein Schließen des Dichtsitzes zwischen dem Ventilschließkörper und der Ventilsitzfläche erzielt werden.

### Kurze Beschreibung der Zeichnungen

Bevorzugte Ausführungsbeispiele der Erfindung sind in der nachfolgenden Beschreibung anhand der beigefügten Zeichnungen näher erläutert. Es zeigt:
Fig. 1 ein Einspritzsystem in einer auszugsweisen, schematischen Darstellung entsprechend einem Ausführungsbeispiel der Erfindung und
Fig. 2 ein schematisches Diagramm zur Erläuterung der Funktionsweise des Einspritzsystems entsprechend dem Ausführungsbeispiel der Erfindung.

### Ausführungsformen der Erfindung

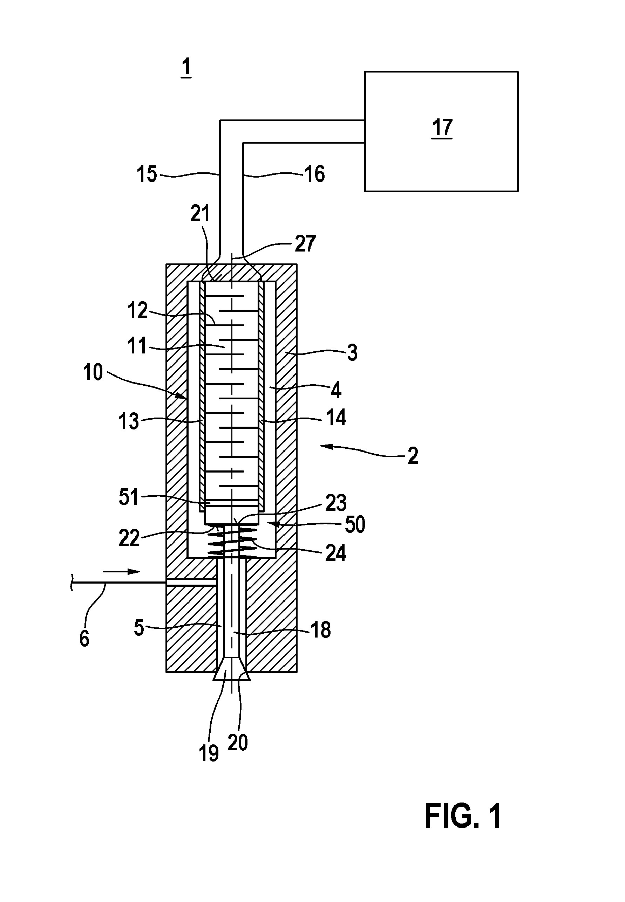

Fig. 1 zeigt ein Einspritzsystem 1 in einer schematischen Darstellung entsprechend einem Ausführungsbeispiel der Erfindung. Das Einspritzsystem 1 kann insbesondere als Brennstoffeinspritzanlage ausgestaltet sein. Das Einspritzsystem 1 weist ein Einspritzventil 2 auf, das als Brennstoffeinspritzventil 2 ausgestaltet sein kann. Hierbei können mehrere Einspritzventile 2 vorgesehen sein. Ein bevorzugter Einsatz des Einspritzsystems 1 besteht für luftverdichtende, selbstzündende Brennkraftmaschinen oder für gemischverdichtende, fremdgezündete Brennkraftmaschinen. Das Einspritzsystem 1 der Erfindung eignet sich jedoch auch für andere Anwendungsfälle.

Das Einspritzventil 2 weist ein Ventilgehäuse 3 auf, in dem ein Aktorraum 4 und ein Brennstoffraum 5 ausgestaltet sind. Hierbei ist Brennstoff über eine Brennstoffleitung 6 in den Brennstoffraum 5 des Ventilgehäuses 3 führbar.

In dem Aktorraum 4 des Ventilgehäuses 3 ist ein piezoelektrischer Aktor 10 des Einspritzsystems 1 angeordnet. Der piezoelektrische Aktor 10 weist eine Vielzahl von keramischen Schichten 11 und eine Vielzahl von zwischen den keramischen Schichten angeordneten Elektrodenschichten 12 auf. Die Elektrodenschichten 12 sind hierbei abwechselnd mit Außenelektrodenanbindungen 13, 14 verbunden. Die Außenelektrodenanbindungen 13, 14 sind auf geeignete Weise mit elektrischen Leitungen 15, 16 kontaktiert, die in das Ventilgehäuse 3 geführt sind. Über die elektrischen Leitungen 15, 16 ist der piezoelektrische Aktor 10 mit einer Steuerung 17 verbunden.

Die Steuerung 17 kann hierbei Teil eines Steuergeräts oder dergleichen sein. Ferner kann die Steuerung 17 neben dem Einspritzventil 2 auch weitere Einspritzventile ansteuern.

Das Einspritzventil 2 weist ein Ventilelement 18 auf, das in diesem Ausführungsbeispiel als Düsennadel 18 ausgestaltet ist. Hierbei ist an dem Ventilelement 18 ein Ventilschließkörper 19 ausgestaltet, der mit einer Ventilsitzfläche 20 zu einem Dichtsitz zusammenwirkt.

Der piezoelektrische Aktor 10 ist an einer Stirnseite 21 an dem Ventilgehäuse 3 abgestützt. An einer weiteren Stirnseite 22 des Aktors 10 wirkt der Aktor 10 mit einer Stirnseite 23 des Ventilelements 18 zusammen. Hierbei ist außerdem eine Ventilfeder 24 vorgesehen, die sich an der Stirnseite 22 des Aktors 10 abstützt und den Aktor 10 mit einer Vorspannung beaufschlagt.

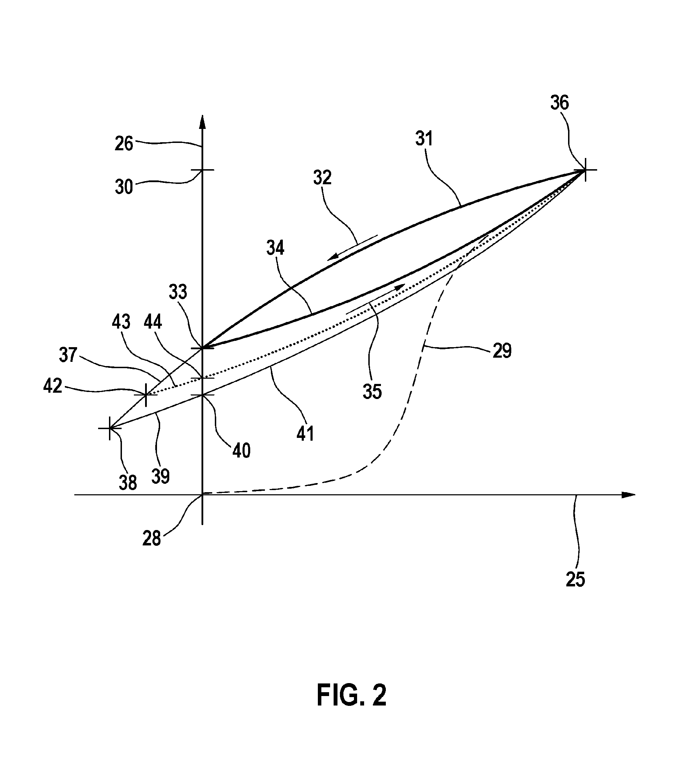

Die Ausgestaltung und Funktionsweise des Einspritzsystems 1 ist im Folgenden auch unter Bezugnahme auf die Fig. 2 im weiteren Detail beschrieben.

Fig. 2 zeigt ein Diagramm zur Illustration der Funktionsweise des Einspritzsystems 1. Hierbei ist an der Abszisse 25 das durch Anlegen einer Spannung zwischen die elektrischen Leitungen 15, 16 in einer keramischen Schicht 11 erzeugte elektrische Feld angetragen. An der Ordinate 26 ist eine Dehnung des piezoelektrischen Aktors 10 entlang einer Längsachse 27 angetragen. Hierbei ist anzumerken, dass sich das an der Abszisse 25 angetragene elektrische Feld auf beispielsweise eine keramische Schicht 11 bezieht, da die einzelnen keramischen Schichten 11 des Aktors 10 wechselweise entgegengesetzt zueinander polarisiert sind.

In einem Ausgangszustand 28 ist der Aktor 10 nicht polarisiert. Dann wird der Aktor 10 polarisiert, so dass entsprechend dem Verlauf der unterbrochen dargestellten Linie 29 ein Polarisationszustand in dem Aktor 10 erzeugt wird, der beim Erreichen eines Maximalwerts zu einer Dehnung 30 führt. Beim anschließenden Entladen des Aktorkörpers 10 wird der Ausgangszustand 28 nicht mehr angenommen. Beim Verringern des elektrischen Feldes, das heißt Absenken der elektrischen Spannung auf 0 V, gelangt der Zustand des Aktors 10 entlang der Kurve 31 in einer Richtung 32 zu einem Punkt 33. Wird der Aktor anschließend wieder geladen, dann läuft der Zustand des Aktors 10 entlang einer Kurve 34 in einer Richtung 35, so dass wieder der Punkt 36 mit der Dehnung 30 erreicht wird.

Das Laden und Entladen des Aktors 10 zwischen den Punkten 36, 33 entlang der Kurven 31, 34 in den Richtungen 32, 35 entspricht einer normalen unipolaren Ansteuerung des Aktors 10. Hierbei tritt eine Hysterese auf, die durch die linsenförmige Ausgestaltung der aus den Kurven 31, 34 zusammengesetzten Gesamtkurve 31, 34 ersichtlich ist.

Der Remanenzzustand des piezoelektrischen Materials des Aktors 10 kann dem Punkt 33 entnommen werden. Gekoppelt mit diesem Remanenzzustand ist auch eine Länge des Aktors 10, die direkt abhängt von der zuvor erfolgten elektrischen Ansteuerung. Bei der ersten elektrischen Belastung entlang der unterbrochen dargestellten Linie 29 bildet sich dieser Remanenzzustand aus, so dass der Aktor 10 die permanente Längenausdehnung am Punkt 33 erfährt. Wenn der Aktor 10 nur noch in positiver Feldrichtung, das heißt mit positiver Spannung und somit unipolar, elektrisch belastet wird, dann stellt sich ein relativ hoher, stabiler Remanenzzustand am Punkt 33 ein, welcher bei einer konstanten Temperatur nicht variabel ist.

Wird das keramische Material des piezoelektrischen Aktors 10 hingegen mit einer leicht negativen elektrischen Spannung, das heißt quasi bipolar, belastet, dann kann eine Verringerung des Remanenzzustands des keramischen Materials erreicht werden. Hierfür wird der Aktor 10 entgegen der Polarisation angesteuert. Ausgehend vom Punkt 36 kann hierbei die Kurve 31 durchlaufen werden, wobei sich zusätzlich ein Kurvenabschnitt 37 anschließt, so dass ein Punkt 38 erreicht wird. Gegenüber dem Punkt 33 kann am Punkt 38 eine Verkürzung des Aktors 10 erzielt werden. Wird die Spannung anschließend wieder auf 0 V erhöht, also betragsmäßig auf 0 V abgesenkt, dann wird beispielsweise entlang des Kurvenabschnitts 39 der Punkt 40 erreicht. Am Punkt 40 verschwindet die angelegte Spannung. Zusätzlich ist auch beim Erhöhen der Spannung auf 0 V gegenüber dem Punkt 33 eine bleibende Verkürzung erzielt worden, wie es der Vergleich der Punkte 33, 40 in Bezug auf die Ordinate 26, an der die Dehnung des Aktors 10 angetragen ist, zeigt. Beim anschließenden Anlegen einer positiven Spannung an den Aktor 10 wird ein Kurvenabschnitt 41 durchlaufen, so dass wieder der Punkt 36 erreicht wird. Die Kurvenabschnitte 39, 40 können hierbei im Betrieb gemeinsam in der Richtung 35 durchlaufen werden. Anschließend kann wiederum die Kurve 31 in der Richtung 32 durchlaufen werden, wobei sich zusätzlich der Kurvenabschnitt 37 anschließen kann.

Die Länge des Kurvenabschnitts 37 kann durch den Spannungsverlauf variiert werden. Beispielsweise kann der Kurvenabschnitt 37 auch nur bis zu einem Punkt 42 durchlaufen werden. Auch beim Punkt 42 wird eine Verkürzung des Aktors 10 gegenüber dem Punkt 33 erreicht. Wenn anschließend die unterbrochen dargestellte Kurve 43 durchlaufen wird, dann wird beim Erreichen einer Spannung von 0 V der Punkt 44 durchlaufen. Am Punkt 44 ist der Aktor 10 gegenüber dem Punkt 33 ebenfalls verkürzt. Somit kann je nach Größe des negativen elektrischen Feldes eine proportionale Verkürzung des Aktors 10 erzielt werden.

Der Remanenzzustand, der beispielsweise am Punkt 33 veranschaulicht ist, ändert sich stark mit der Temperatur, wobei er bei hoher Temperatur geringer ist. Die quasi bipolare Ansteuerung kann somit auch zur Kompensation der temperaturbedingten Remanenzänderung dienen.

Das Einspritzventil ist konstruktiv so ausgelegt, dass zwischen dem Aktor 10 und dem Ventilelement 18 bei einer mittleren quasi bipolaren Ansteuerung, das heißt einer mittleren Länge des Aktors 10, kein Spalt in einem Bereich 50 zwischen der Stirnseite 22 des Aktors 10 und der Stirnseite 23 des Ventilelements 18 auftritt. Dadurch können im Betrieb auftretende Spalte durch eine adaptive Längenänderung des Aktors 10 ausgeglichen und somit vermieden werden. Hierzu stellt die Steuerung 17 die Größe der negativen Feldkomponente entsprechend ein. Hierdurch wird ein angepasster Remanenzzustand, beispielsweise einer der Punkte 40, 44, eingestellt.

Somit steuert die Steuerung 17 den Aktor 10 entsprechend der Polarisierung des Aktors 10 und entgegen der Polarisierung des Aktors 10 an. Hierbei wird durch die Ansteuerung des Aktors 10 entgegen der Polarisierung des Aktors 10 erreicht, dass eine Wirkverbindung zwischen dem Aktor 10 und dem Ventilelement 18 erzielt ist.

Zur Erfassung, wann sich der Aktor 10 in direktem Kontakt mit dem Ventilelement 18 befindet, kann der Aktor 10 selbst dienen. Hierbei kann der direkte piezoelektrische Effekt der keramischen Schichten 11 des Aktors 10 ausgenutzt werden, wonach es bei mechanischer Belastung der keramischen Schichten 11 zu einer proportionalen Ladungserzeugung auf den Keramikoberflächen kommt, die über die elektrischen Leitungen 15, 16 erfassbar ist.

Außerdem ist es möglich, dass in den Aktor 10 ein Sensorelement 51 integriert ist, welches ebenfalls aus Piezokeramik bestehen kann. Das Sensorelement 51 kann hierbei über geeignete Signalleitungen mit der Steuerung 17 verbunden werden. Diese Signale können gegebenenfalls auch über die elektrischen Leitungen 15, 16 zu der Steuerung 17 geführt werden. Hierbei wird ebenfalls ausgenutzt, dass bei mechanischer Belastung der Keramik des Sensorelements 51 eine proportionale Ladungserzeugung auf der Keramikoberfläche entsteht, die erfasst wird.

Über das Sensorelement 51 kann auch eine mechanische Spannung erfasst werden, die mit einer mechanischen Sollspannung verglichen wird. Die Steuerung 17 kann hierbei einen Abgleich der erfassten mechanischen Spannung mit der vorgegebenen Sollspannung vornehmen, so dass durch entsprechendes Ansteuern des Aktors 10 die mechanische Spannung zumindest näherungsweise gleich der vorgegebenen mechanischen Sollspannung ist.

Hierdurch kann gewährleistet werden, dass der Aktor 10 immer mit einer vorgegebenen, konstanten Anpresskraft an dem Ventilelement 18 anliegt.

Somit ist eine vorteilhafte Ansteuerung des Ventilelements 18 möglich, wodurch in vorteilhafter Weise der Hub des Aktors 10 zum Betätigen des Ventilschließkörpers 19 dient. Bei einer Betätigung des Ventilschließkörpers 19 hebt sich dieser von der Ventilsitzfläche 10 ab, so dass der Dichtsitz zwischen dem Ventilschließkörper 19 und der Ventilsitzfläche 20 geöffnet wird und Brennstoff aus dem Brennstoffraum 5 beispielsweise in einen Brennraum einer Brennkraftmaschine eingespritzt wird.

Das Ventilgehäuse 3 kann ganz oder teilweise aus geeigneten Werkstoffen gebildet sein, so dass temperaturbedingte Längenänderungen in der Wirkungsverbindung zwischen dem Aktor 10 und dem Ventilelement 18 reduziert sind. Ferner kann das Einspritzventil 2 ohne einen hydraulischen Koppler oder dergleichen ausgestaltet sein, der Längenänderungen ausgleicht. Auch andere Ausgleichselemente sind nicht erforderlich. Somit ist eine kompakte und kostengünstige Realisierung des Einspritzventils 2 möglich.

Beispielsweise kann eine mechanische Vorspannung des Aktors 10 von 100 N vorgegeben sein. Falls die mechanische Vorspannung auf beispielsweise 180 N oder mehr ansteigt, dann ist der Dichtsitz zwischen dem Ventilschließkörper 19 und der Ventilsitzfläche 20 permanent geöffnet. Ein vollständiges Schließen ist zu diesem Zeitpunkt mit einer elektrischen Ansteuerung des Aktors 10 von 0 V, beispielsweise am Punkt 33, nicht mehr möglich. Durch Ansteuern des Aktors 10 entgegen seiner Polarisation kann der Aktor 10 aber verkürzt werden, so dass sich auch die Vorspannung verringert. Beispielsweise kann eine Ansteuerung entgegen der Polarisation bis zu dem Punkt 42 oder bis zu dem Punkt 38 erfolgen. Hierbei wird eine Ausgangslänge des Aktors 10 am Punkt 33 durch eine Ansteuerung des Aktors 10 entgegen seiner Polarisation verringert. Dies ergibt eine negative Längenänderung der Ausgangslänge des Aktors 10. Durch eine betragsmäßige Vergrößerung der Ansteuerung des Aktors 10 entgegen seiner Polarisation kann die Ausgangslänge gegebenenfalls weiter verkürzt werden. Dies ergibt ebenfalls eine negative Längenänderung der Ausgangslänge des Aktors 10. Speziell kann die mechanische Vorspannung des Aktors auf diese Weise wieder auf 100 N eingestellt werden. Ein Schließen des Dichtsitzes ist dann wieder möglich. Durch ein varüertes Ansteuern des Aktors 10 entgegen seiner Polarisierung kann somit stets eine geeignete mechanische Vorspannung erreicht werden. Insbesondere kann eine Regelung auf eine vorgegebene mechanische Sollspannung von beispielsweise 100 N erfolgen.

Die Erfindung ist nicht auf die beschriebenen Ausführungsbeispiele beschränkt.

## Patentansprüche

1. Einspritzsystem (1), insbesondere Brennstoffeinspritzanlage, mit einem Aktor (10), einem von dem Aktor (10) zumindest mittelbar betätigbaren Ventilschließkörper (19), der mit einer Ventilsitzfläche (20) zu einem Dichtsitz zusammenwirkt, und einer mit dem Aktor (10) verbundenen Steuerung (17), die zur Ansteuerung des Aktors (10) dient, wobei die Steuerung (17) ausgestaltet ist, den Aktor (10) entsprechend einer Polarisierung des Aktors (10) und entgegen der Polarisierung des Aktors (10) anzusteuern, und wobei die Steuerung (17) ausgestaltet ist, den Aktor (10) so entgegen der Polarisierung des Aktors (10) anzusteuern, dass ein Schließen des zwischen dem Ventilschließkörper (19) und der Ventilsitzfläche (20) gebildeten Dichtsitzes ermöglicht ist.

2. Einspritzsystem nach Anspruch 1,
**dadurch gekennzeichnet,**
**dass** der Aktor (10) ein Sensorelement (51) aufweist, das zum Erfassen einer mechanischen Spannung in der Wirkverbindung zwischen dem Aktor (10) und dem Ventilschließkörper (19) dient, und dass die Steuerung (17) ausgestaltet ist, den Aktor (10) in Abhängigkeit von der von dem Sensorelement (51) erfassten mechanischen Spannung auch entgegen der Polarisierung des Aktors (10) anzusteuern.

3. Einspritzsystem nach Anspruch 2,
**dadurch gekennzeichnet,**
**dass** die Steuerung (17) ausgestaltet ist, den Aktor (10) so anzusteuern, dass die von dem Sensorelement (51) erfasste mechanische Spannung zumindest näherungsweise gleich einer vorgegebenen mechanischen Sollspannung ist.

4. Einspritzsystem nach einem der Ansprüche 1 bis 3,
**dadurch gekennzeichnet,**
**dass** der Aktor (10) so angeordnet ist, dass in einem Ausgangszustand bei einer teilweisen oder verschwindenden Ansteuerung des Aktors (10) entsprechend der Polarisierung des Aktors (10) ein Schließen des zwischen dem Ventilschließkörper (19) und der Ventilsitzfläche (20) gebildeten Dichtsitzes ermöglicht ist.

5. Einspritzsystem nach einem der Ansprüche 1 bis 4,
**dadurch gekennzeichnet,**
**dass** der Ventilschließkörper (19) an einem Ventilelement (18) ausgebildet ist und dass der Aktor (10) das Ventilelement (18) direkt ansteuert.

6. Einspritzsystem nach einem der Ansprüche 1 bis 5,
**dadurch gekennzeichnet,**
**dass** die Steuerung (17) so ausgestaltet ist, dass zum Verhindern eines permanent offenen Dichtsitzes zwischen dem Ventilschließkörper (19) und der Ventilsitzfläche (20) eine negative Längenänderung einer Ausgangslänge des Aktors (10) durch Ansteuern des Aktors (10) entgegen der Polarisierung des Aktors (10) erzielt ist.

7. Einspritzsystem nach einem der Ansprüche 1 bis 6,
**dadurch gekennzeichnet,**
**dass** die Steuerung (17) so ausgestaltet ist, dass zum Verhindern eines permanent offenen Dichtsitzes zwischen dem Ventilschließkörper (19) und der Ventilsitzfläche (20) eine negative Längenänderung einer Ausgangslänge des Aktors (10) durch betragsmäßig vergrößertes Ansteuern des Aktors (10) entgegen der Polarisierung des Aktors (10) erzielt ist.

8. Einspritzsystem nach einem der Ansprüche 1 bis 7,
**dadurch gekennzeichnet,**
**dass** ein Ventilgehäuse (3) vorgesehen ist und dass der piezoelektrische Aktor (10) an einer Stirnseite (21) an dem Ventilgehäuse (3) abgestützt ist und dass ein Abstand der Stirnseite (21) des Aktors (10) von dem Ventilgehäuse (3) durch die Abstützung fest vorgegeben ist.

9. Einspritzsystem nach Anspruch 8,
**dadurch gekennzeichnet,**
**dass** zumindest ein Werkstoff des Ventilgehäuses (3) so vorgegeben ist, dass temperaturbedingte Längenänderungen in der Wirkverbindung zwischen dem Aktor (10) und dem Ventilschließkörper (19) reduziert sind.
